# EUROPEAN PATENT APPLICATION

(11) **EP 2 709 145 A2**
(43) Date of publication of application: **19.03.2014**
(21) Application number: 13182996.2
(22) Date of filing: 04.09.2013
(51) Int. Cl.: H01L 21/66

(54) **Inline metrology for attaining full wafer map of uniformity and surface charge**

(30) Priority: 14.09.2012 US 201213619817
(71) Applicant: STMicroelectronics, Inc., Coppell, TX 75019 (US)
(72) Inventor: Zhang, John H, Altamont, NY New York 12009 (US)
(74) Representative: Style, Kelda Camilla Karen

(57) **Abstract**

An apparatus for performing metrology of a wafer. The apparatus may include a substrate with a plurality of microprobes (520). A plurality of light sources may direct light onto each of the microprobes (520). Light reflected from the microprobes may be detected by a plurality of photodetectors thereby generating a detection signal associated with each of the microprobes. A controller (610)may send a driving signal to each of the plurality of microprobes and determine a height profile and a surface charge profile of the wafer based on each of the detection signals.

## Description

### BACKGROUND

Semiconductor devices may be manufactured using a variety of tools, such as deposition tools and chemical mechanical polishing (CMP) tools. A semiconductor device is typically manufactured on a semiconductor wafer comprising a plurality of semiconductor devices. Deposition tools may be used to add material to the devices, while CMP tools may be used to remove material from the devices and planarize the surface of the wafer. When a layer of a material is added to a device, the top surface of the added layer may be non-uniform due to the topology of the underlying portions of the devices. Accordingly, a CMP tool may be used to remove portions of the added layer and planarize the layer across each individual device and across the wafer as a whole.

A CMP tool may comprise a plurality of CMP modules, each performing a polishing process. A polishing process of a fabrication process may include undergoing a polishing act by the plurality of CMP modules. For example, a first CMP module may quickly remove the bulk of a material on the wafer, whereas a second CMP module may more precisely and slowly remove the remaining amount of the material.

Before removing material from a wafer, it is known to use inline metrology devices, such as an eddy current measurement device, to measure properties of the wafer. The wafer properties may be used to determine parameters for the first polishing act by a first CMP module. It is also known to use in situ measurements of the wafer to determine the end point of each polishing act.

Over the years, semiconductor devices have been designed for faster switching speeds and greater functionality. An approach to achieving devices with these capabilities has been to decrease the size of features within the semiconductor devices.

### SUMMARY

The inventor has recognized that as the feature size of semiconductor devices decreases, local and global uniformity across the wafer during the fabrication process becomes critical to manufacturing devices with long lifetimes and low failure rates. The uniformity of a wafer may change in unpredictable ways throughout the polishing stage of semiconductor device manufacturing. Some embodiments may use techniques for feeding back wafer measurements from both an inline metrology device and in situ wafer measurements at each CMP module to control subsequent polishing parameters.

The inventor has recognized that local and global uniformity across the wafer may be determined more quickly and precisely using a single inline measurement apparatus with a plurality of microprobes. Some embodiments may be apparatuses for performing inline metrology and methods of using an inline metrology device to manufacture a semiconductor device.

Some embodiments are directed to a method of manufacturing a semiconductor device. A semiconductor wafer may be measured to determine at least one property of the wafer, which may be at least one property of a top surface of the semiconductor wafer. For example, it may be a uniformity of the top surface of the semiconductor wafer. The at least one property may be used to determine a recipe for processing the semiconductor wafer. A plurality of polishing modules, which may be CMP modules, then process the semiconductor wafer according to the recipe. The recipe may include a value of at least one parameter for use by each of the plurality of polishing modules. The at least one parameter specified by the recipe may be a pressure, a slurry flow, a rotation speed and/or a time duration.

In some embodiments, the method may include processing the semiconductor wafer with a cleaning module based on the determined recipe. The recipe includes a value for at least one parameter for the cleaning module. The at least one parameter for the cleaning module may indicate a chemistry type to be used by the cleaning module.

Some embodiments are directed to a semiconductor processing device for processing a semiconductor wafer. The device may include a plurality of polishing modules, which may be CMP modules. Each polishing module may include an interface to receive at least one parameter specifying how to process the semiconductor wafer. The semiconductor processing device may also include an inline metrology device configured to measure at least one property of the semiconductor wafer. The at least one property may be at least one property of a top layer of the semiconductor wafer. The device may also include a controller configured to: receive the at least one property of the semiconductor wafer from the inline metrology unit; generate at least one respective parameter for each polishing module specifying how to process the semiconductor wafer; and transmit the at least one respective parameter to each of the plurality of polishing modules. The at least one parameter received by each polishing module may include parameters such as a pressure, a slurry flow, a rotation speed, and/or a time duration.

In some embodiments, the semiconductor processing device includes a cleaning module for cleaning the semiconductor wafer based on at least one cleaning parameter. The controller may be configured to: generate the at least one cleaning parameter specifying how to clean the semiconductor wafer based on the at least one property of the semiconductor wafer; and transmit the at least one cleaning parameter to the cleaning module. The at least one cleaning parameter may indicate a chemistry type to be used by the cleaning module.

Some embodiments are directed to a method of manufacturing a semiconductor device. A first polishing module may process a semiconductor wafer. The semiconductor wafer may be measured to determine a first property in situ while the first polishing module is processing the semiconductor wafer. A first parameter for processing the semiconductor wafer may be determined based on the first property. A second polishing module may process the semiconductor wafer based on the first parameter. The first parameter may be a parameter such as a pressure, a slurry flow, a rotation speed and/or a time duration. The first property may be a uniformity of the top surface of the semiconductor wafer

In some embodiments, before processing the semiconductor wafer with a first polishing module, the method may measure a second property with an inline measurement device. A second parameter for processing the semiconductor wafer may be determined based on the second property. The processing of the semiconductor wafer with the first polishing module may be performed based on the second parameter. In some embodiments, the polishing modules may be CMP modules.

Some embodiments are directed to an apparatus for performing metrology of a wafer. The apparatus may include a plurality of microprobes on a substrate. At least one light source may direct light onto each of the plurality of microprobes. A plurality of photodetectors may detect the light reflected from each of the plurality of microprobes. Detecting the light may generate a detection signal associated with each of the microprobes. The apparatus may include at least one controller for sending a driving signal to each of the plurality of microprobes and determining a height profile and a surface charge profile of the wafer based on each of the detection signals.

In some embodiments, the wafer being measured may comprise a plurality of devices. The plurality of microprobes may comprise a plurality of subsets, each of the plurality of subsets comprising one or more of the plurality of microprobes, wherein each of the plurality of subsets may be associated with one of the plurality of devices of the wafer. Each of the plurality of subsets may include more than one of the plurality of microprobes. In some embodiments, the at least one controller may transmit at least one fabrication parameter to a fabrication tool for processing the wafer. In some embodiments, a protective membrane may protect each of the plurality of microprobes. The protective membrane may be formed from a porous material, which may have a pore size of between 20 nm and 200 nm. The porous material may be a zeolite compound or a metal-organic framework.

In some embodiments, each of the plurality of photodetectors may be a segmented photodiode comprising a plurality of segments, The detection signal may include a plurality of segment signals, each from a respective segment of the photodiode. The height profile and surface charge profile may be determined from the plurality of segment signals. In some embodiments, the light reflected from each microprobe may be input into an interferometer. The interferometer may comprise an integrated optical circuit.

Some embodiments are directed to a method of manufacturing a semiconductor device on a wafer. A measurement probe which may comprise a plurality of microprobes may be provided. A controller may send a driving signal to each of the plurality of microprobes. Light may be directed to each of the microprobes and reflected light may be detected from each of the microprobes. A detection signal associated with each of the microprobes may be generated and a height profile and a surface charge profile of the wafer may be determined based on the detection signals associated with each of the plurality of microprobes. The measurement probe may be scanned over a surface of the wafer.

An apparatus for performing metrology of a wafer, the apparatus may comprise a substrate; a plurality of microprobes on the substrate; at least one light source, wherein the at least one light source directs light onto one of the plurality of microprobes; a plurality of photodetectors for detecting the light reflected from each of the plurality of microprobes, wherein detecting the light comprises generating a detection signal associated with each of the microprobes; and at least one controller for: sending a driving signal to each of the plurality of microprobes; and determining a height profile and a surface charge profile of the wafer based on each of the detection signals.

The wafer may comprise a plurality of devices; and the plurality of microprobes may comprise a plurality of subsets, each of the plurality of subsets comprising one or more of the plurality of microprobes, wherein each of the plurality of subsets is associated with one of the plurality of devices of the wafer.

Each of the plurality of subsets may comprise more than one of the plurality of microprobes.

In response to the determined height profile and the determined surface profile, the at least one controller may transmit at least one fabrication parameter to a fabrication tool for processing the wafer.

The apparatus may further comprise a plurality of protective membranes for protecting a the plurality of microprobes.

The plurality of protective membranes may be formed from a porous material.

The porous material may have a pore size between 20 nm and 200 nm.

The porous material may be a zeolite compound or a metal-organic framework.

Each of the plurality of photodetectors may be a segmented photodiode comprising a plurality of segments; the detection signal may comprise a plurality of segment signals, each of the plurality of segment signals being from a respective segment of the photodiode; and the height profile and surface charge profile may be determined from the plurality of segment signals.

Before being detected by the plurality of photodetectors, the light reflected from each of the plurality of microprobes may be input into a respective interferometer.

Each respective interferometer may comprise an integrated optical circuit.

The substrate may be a semiconductor wafer.

A method of manufacturing a semiconductor device on a wafer, the method may comprise providing a measurement probe comprising a plurality of microprobes; sending a driving signal to each of the plurality of microprobes; directing light onto each of the plurality of microprobes; detecting the light reflected from each of the plurality of microprobes; generating a detection signal associated with each of the microprobes; and determining a height profile and a surface charge profile of the wafer based on each of the detection signals.

The method may further comprise scanning the measurement probe over a surface of the wafer.

The wafer may comprise a plurality of semiconductor devices; and the plurality of microprobes may comprise a plurality of subsets, each of the plurality of subsets comprising one or more of the plurality of microprobes, wherein each of the plurality of subsets is scanned over only one of the plurality of devices of the wafer.

Each of the driving signals may be generated based in part on a respective detection signal.

Detecting the light reflected from each of the plurality of microprobes may comprise detecting the reflected light at a respective segmented photodiode comprising a plurality of segments; each of the detection signals may comprise a plurality of segment signals, each of the plurality of segment signals being from a respective segment of the respective segmented photodiode; and the height profile and surface charge profile may be determined from the plurality of segment signals.

The method may further comprise directing the light reflected from each of the plurality of microprobes through an interferometer.

The method may comprise transmitting at least one fabrication parameter to a fabrication tool for processing the wafer, wherein the at least one fabrication parameter may be based on the height profile and/or the surface charge profile.

Directing the light onto each of the plurality of microprobes may comprise emitting the light from a laser and directing a portion of light onto each of the plurality of microprobes.

### BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a block diagram of an exemplary polishing tool;
FIG. 2 is a flow chart of a first exemplary method for polishing a semiconductor wafer;
FIG. 3 is a flow chart of a second exemplary method for polishing a semiconductor wafer;
FIG. 4 is a flow chart of a third exemplary method for polishing a semiconductor wafer;
FIG. 5 illustrates a measurement probe for performing metrology of a wafer;
FIG. 6 illustrates a first exemplary embodiment of portions of a measurement probe;
FIG. 7 illustrates a second exemplary embodiment of portions of a measurement probe; and
FIG. 8 is a flow chart of a method for producing a semiconductor device.

### DETAILED DESCRIPTION

The inventor has recognized and appreciated that as the feature size of semiconductor devices decreases, local and global uniformity across the wafer during the fabrication process plays a more important role in manufacturing devices with long lifetimes and low failure rates. The inventor has further recognized and appreciated the uniformity of a wafer, both locally and globally, may be improved by feeding back measurements from an inline metrology device and/or in situ wafer measurements at one or more modules of a polishing tool. The measurements may be used to control subsequent acts of the polishing process, thereby allowing better control of the wafer uniformity during the polishing process.

It is known to use in situ measurements to determine an endpoint of an individual polishing act performed by a polishing module. However, the inventor has appreciated that more precise control of the wafer properties may be achieved by dynamically selecting the properties of subsequent acts of a fabrication recipe based on in situ measurements made by one or more polishing modules of a polishing tool.

The inventor has also recognized and appreciated that local and global uniformity across the wafer may be determined more quickly and precisely using a single inline measurement apparatus with a plurality of microprobes. The inline measurement stage of semiconductor manufacturing may be a bottleneck in the fabrication process. By reducing the time it takes to make these inline measurements, the measurements may be fed back to fabrication tools faster allowing semiconductor devices to be manufactured more quickly. The inventor has further recognized and appreciated that faster inline measurements may be made by using a measurement apparatus with a plurality of microprobes.

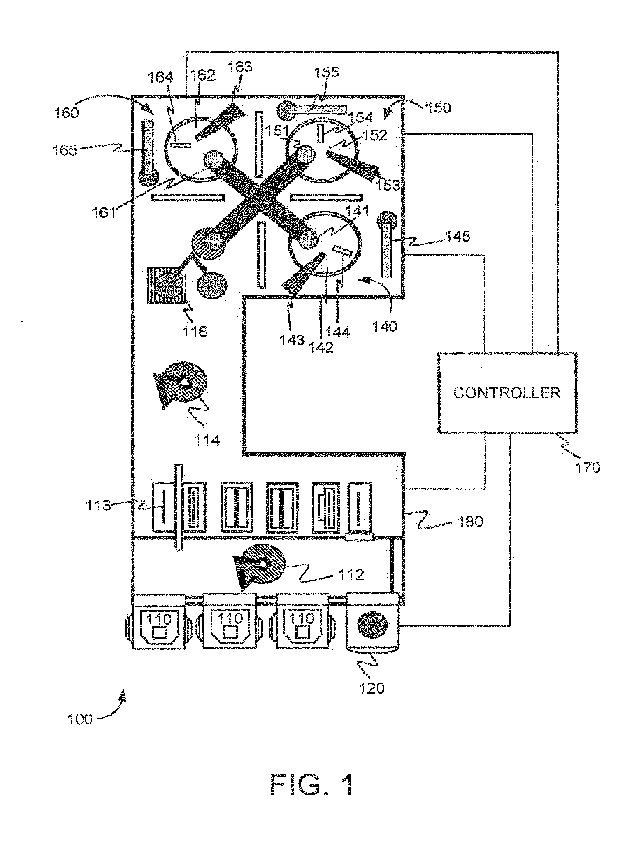

FIG. 1 is a block diagram illustrating an exemplary polishing tool 100 of some embodiments. Polishing tool 100 is illustrated as a chemical mechanical polishing (CMP) tool. However, any suitable polishing tool may be used. For example, a free abrasive polishing tool or a chemical etching tool may be used.

The polishing tool 100 comprises a plurality of CMP modules 140, 150 and 160. FIG. 1, by way of example, illustrates three CMP modules. However, it should be appreciated that any number of CMP modules may be used. Each CMP module may perform a polishing act of an overall polishing process. Each CMP module may perform a polishing act with a different set of polishing parameters. The polishing parameters for each CMP module may be determined in any suitable way, for example, based on feedback from measurements performed by at least one other CMP module or an inline metrology device 120.

Semiconductor devices being fabricated using CMP tool 100 are loaded into the tool via a load lock 110. Any suitable number of load locks 110 may be used. For example, FIG. 1 illustrates three load locks 110. Any suitable number of semiconductor devices may be loaded into load lock 110 at a time. For example, a single wafer, comprising a plurality of semiconductor devices, may be loaded into load lock 110. Moreover, a cassette occupied by a plurality of wafers may be loaded into load lock 110.

The semiconductor device being loaded into load lock 110 may be at any stage of the manufacturing process. For example, the manufacturing process may be segregated into two portions, referred to as front end of line (FEOL) and back end of line (BEOL). FEOL refers to the first portion of device fabrication where individual elements of the device are patterned in the semiconductor. BEOL refers to the second portion of device fabrication where the individual elements of the device are interconnected. The CMP tool 100, in some embodiments, is responsible for only the BEOL processing or only FEOL processing. However, embodiments are not so limited.

Once a semiconductor wafer is loaded into load lock 110, a transfer mechanism 112 is used to remove the wafer from load lock 110. Any suitable transfer mechanism 112 may be used. For example, transfer mechanism 112 may be a robot arm. However, other transfer mechanisms may be used, such as a vacuum hose that holds the semiconductor device using suction or a conveyor. More than one transfer mechanism may be used. For example, as illustrated in FIG. 1, transfer mechanism 112 may pass the semiconductor device through a passage 113 to a second transfer mechanism 114. Transfer mechanism 114 may pass the semiconductor device to one of the CMP modules 140, 150 or 160.

CMP tool 100 comprises a plurality of CMP modules 140, 150 and 160. Techniques for performing CMP are known and embodiments are not limited to any particular implementation of CMP. Each CMP module 140/150/160 may comprise components such as a slurry dispersion arm 143/153/163, a condition arm 145/155/165, a platen 142/152/162, a platen process window 144/154/164 and a CMP head 141/151/161. The CMP modules 140/150/160 and the components thereof may be constructed using techniques known in the art. The semiconductor device may be processed by each of the plurality of CMP modules in turn. For example, each CMP module may use different parameters in performing CMP. The parameters that may be varied include, but are not limited to, the rotation speed of the platen, the rate of slurry dispersion, the duration, and the pressure. The parameters used by each CMP module may be determined, for example, by controller 170.

Platen process windows 144/154/164 may be used to perform in situ measurements of the wafer during the fabrication process. Measurements may be made while a wafer is being polished by the respective CMP module. Alternatively, or in addition, measurements may be made before and/or after the polishing is performed by each CMP module. Any suitable measurement may be performed and many different types of in situ measurements are known to one of ordinary skill in the art. For example, various forms of optical, x-ray, acoustic, conductivity, and friction sensing techniques are known in the art.

Slurry dispersion arms 143/153/163 deposit a chemical slurry onto platens 142/152/162, respectively. The slurry may comprise a suspension of abrasive particles that aid in polishing the surface of a semiconductor wafer. Controller 170 may determine one or more parameters of the slurry dispersion for each CMP module. For example, controller 170 may determine the rate of flow that the slurry is dispersed by the slurry dispersion arms 143/153/163. Each rate of flow may be different and may be determined by controller 170 using measurements made at previous acts of the semiconductor device manufacturing process. Other parameters of the slurry dispersion may also be controlled by controller 170. For example, the type of slurry dispersed by slurry dispersion arms 143/153/163 may be different and may be determined by controller 170 based on measurements made previously in the manufacturing process. Different slurries may be more or less abrasive, contain different chemicals, have different particle sizes, and/or different concentrations of particles. In some embodiments, the controller 170 may determine the properties of the slurry used by each CMP module.

Platens 142/152/162 may be flat metal platforms to which abrasive pads are affixed. The platens 142/152/162 rotate to polish the wafer attached to CMP head 141/151/161, respectively. Controller 170 may determine one or more parameters of the platens 142/152/162. For example, controller 170 may determine the rotation speed of each platen. Moreover a pressure at which each platen is applied to each corresponding wafer may be determined. For example, a higher pressure may be used to remove material from a top layer of the wafer quickly, whereas a low pressure may be used to remove material from a top layer of the wafer slowly.

CMP heads 141/151/161 may hold the semiconductor wafer during the fabrication process of each respective CMP module 140/150/160. Each CMP head 141/151/161 may rotate in a direction opposite to the platen. For example, if the platen rotates in a counterclockwise direction, the CMP head may rotate the wafer in a clockwise direction. The controller 170 may determine the speed at which the CMP heads 141/151/161 rotate. Moreover a pressure at which the CMP head applies the wafer to the polishing pad may be determined. In some embodiments, CMP heads 141/151/161 may comprise a plurality of zones. Each zone may be controlled separately such that different pressures are applied in different zones. The zones of a CMP head may be arranged in any suitable way. For example, a plurality of zones may be arranged radially on the CMP head such that each zone is an annulus and the barriers between zones are concentric circles. Each of the plurality of zones may have the same or a different size. Each of the plurality of zones of each CMP head may be separately controlled to apply different pressures. For example, if a circular wafer is determined to have a globally larger height profile near the outer edge of the wafer, then a higher pressure may be applied by the zone corresponding to the outer edge of the wafer. Alternatively, if a circular wafer is determined to have a globally smaller heigh profile near the outer edge of the wafer, then a lower pressure may be applied by the zone corresponding to the outer edge of the wafer.

Condition arms 145/155/165 recondition the abrasive pads used to polish the semiconductor wafer in each respective CMP module. Reconditioning removes particles from the surface of the pad and ensures that the pad remains abrasive so that it may adequately polish the wafer. The condition arms 145/155/165 may use an abrasive condition pad rotating the opposite direction of the platen to recondition the pad. Controller 170 may determine the speed at which the condition pads of the condition arms 145/155/165 rotate and thereby control how much the pad is reconditioned.

CMP tool 100 may also comprise transfer mechanism 116 for receiving the semiconductor device from transfer mechanism 114 and providing the semiconductor device to the CMP head of one of the CMP modules.

The CMP tool 100 may also comprise additional tools. For example, cleaning tool 180 and an inline metrology device 120 may be included in the CMP tool 100. Because the CMP tool 100 implements a wet process using a slurry with many abrasive particles, the cleaning tool 180 may clean the semiconductor device before the manufacturing process is complete. Controller 170 may determine one or more cleaning parameters to be used based on feedback from previous wafer measurements, such as in situ measurements made by one or more of the CMP modules. For example, the type of chemistry used by the cleaning module 180 may be determined by controller 170 based on previous measurement results.

Inline metrology device 120 may be used at various stages of the manufacturing process to measure various properties of the wafer being manufactured. Transfer mechanisms 112, 114 and/or 116 may move wafers to and from the inline metrology device 120. The inline metrology device 120 may be used prior to processing the semiconductor wafer in one or more of the CMP modules 140/150/160. Controller 170 may use the measurement results from inline metrology device 120 to determine polishing parameters for one or more of the CMP modules 140/150/160. Moreover, results from the inline metrology device 120 may be used to determine one or more parameters for the cleaning module. The inline metrology device 120 may also be used after a polishing stage of the manufacturing process. For example, the wafer may be measured by the inline metrology device 120 to determine whether the wafer meets a specification and/or set of tolerances for local and global uniformity. If the specification is not met, the wafer may be sent back for further processing. Alternatively, the wafer may be disposed of if the measurement indicates the wafer is not salvageable.

In some embodiments, the inline metrology device 120 may be an eddy current measurement tool used to measure properties of a metallic layer of the semiconductor device. However, the inline metrology device 120 is not limited to any particular metrology technique. For example, the inline metrology device 120 may utilize one or more Kelvin probe force microscopes to measure the semiconductor device's surface charge profile and/or height profile. Aspects of a Kelvin probe force microscope used in some embodiments will be described in more detail below.

The controller 170 may be implemented in any suitable way. For example, controller 170 may comprise one or more processors capable of executing computer readable instructions saved on one or more storage devices. The computer readable instructions may include control algorithms for selecting appropriate polishing recipes. The controller 170 may be implemented as a single separate unit, as illustrated by FIG. 1, or controller 170 may comprise a plurality of units distributed throughout the CMP tool 100. For example, a portion of controller 170 may be associated with each CMP module 140/150/160, the cleaning module 180 and the inline metrology device 120.

Controller 170 may communicate to the various portions of CMP tool 100 in any suitable way. For example, FIG. 1 illustrates a direct connection between controller 170 and each CMP module 140/150/160, the cleaning module 180 and the inline metrology device 120. These communication lines allow the communication of measured properties from the various portions of the CMP tool 100 to the controller 170. The communication lines also allow the communication of determined parameters for use by the various components of the CMP tool 100 to the respective components. Any suitable communication lines may be used. For example, various network and bus connections are known in the art and may be used in embodiments.

Controller 170 may determine a polishing recipe to be used by the CMP tool 100 based on measurements made at various stages of the wafer fabrication. A polishing recipe may comprise a collection of parameters to be used by each CMP module and/or the cleaning module 180 during the polishing process. Determining a polishing recipe may be done in any suitable way. For example, one or more tables and/or one or more equations may be used to relate the measured properties to polishing parameters of a recipe. For example, inline metrology device 120 may measure one or more properties of the wafer prior to subjecting the wafer to polishing my one or more of CMP modules 140/150/160. Controller 170 may determine parameters for each of the plurality of CMP modules based on the results on the inline measurement. For example, the measured property may be a height profile of the wafer. If there is a height variation across the surface of a wafer, then different pressures may be used by the CMP module at different zones. The various zone pressures may be one or more of the parameters. Also, the measured property may indicate the material used on the top surface of the wafer. This property may be used to determine the type of slurry and/or the speed of the platen rotation. The CMP tool 100 may also perform additional in situ measurements at each CMP module during the wafer fabrication process. Controller 170 may update or change parameters of subsequent polishing and/or cleaning acts based on in situ measurement results. Moreover, the types of in situ measurements performed in a given CMP module may be determined based on the properties measured by the inline metrology device.

In some embodiments, controller 170 may communicate with tools other than the polishing tool. For example, using the measurement results from, for example, the inline metrology device 120, the controller 170 may determine that additional material is to be deposited on the wafer. This may occur, for example, if it is determined that there is a large localized dip in the surface height of the wafer. The controller 170 may determine, as part of the recipe, to send the wafer to a deposition tool to deposit additional material. Furthermore, if a large locallized raised portion is detected by inline metrology tool 120, the controller 170 may determine that the wafer is to be sent to an etching tool, such as a reactive ion etching (RIE) tool. Embodiments are not limited to any particular type of tool that may be used.

Embodiments of the polishing tool 100 are not limited to the example illustrated in FIG. 1. For example, in some embodiments, the polishing tool 100 may be part of a larger, integrated tool that comprises at least one deposition tool and/or at least one etching tool. In such embodiments, the recipe for fabricating the wafer may include parameters for controlling deposition and etching acts as well as parameters for controlling polishing acts.

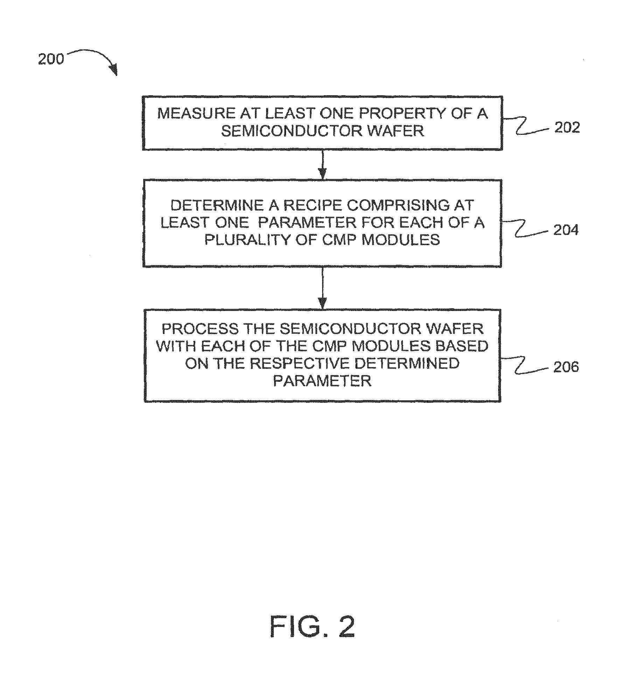

FIG. 2 illustrates a flowchart of an exemplary method 200 for polishing a semiconductor wafer using, for example, CMP tool 100. Embodiments are not limited to necessarily include each act of method 200, nor are embodiments limited from including more acts not illustrated by method 200.

At act 202, at least one property of a semiconductor wafer being produced is measured. This may be done in any suitable way. For example, inline metrology device 120 may measure one or more properties of the wafer. The measured property may be a property of a top layer of the wafer. For example, an eddy current measurement tool may measure conduction properties of a metallic layer of the semiconductor device. Alternatively, a Kelvin force probe microscope may be used to measure the height profile and/or surface charge of a semiconductor wafer.

In some embodiments, the at least one property of a semiconductor wafer may be measured by an in situ measurement device of one of the CMP modules 140/150/160. Embodiments are not limited to the type of measurement made or how the measurement is made. For example, various forms of optical, x-ray, acoustic, conductivity, and friction-based in situ measurement techniques are known in the art.

At act 204, a recipe comprising at least one parameter to be used by each of a plurality of CMP modules is determined. This may be done, for example, by controller 170. Any suitable parameter may be used. As discussed above, each CMP module may be supplied with a rotation speed of the platen, a rotation speed of the CMP head, a rotation speed of the conditioning arm, a pressure associated with the platen, a pressure associated with the CMP head, a slurry flow rate, a type of slurry or any other suitable parameter used to determine properties of a polishing act. In some embodiments, the results of a measurement from inline metrology device 120 may be used to determine at least one parameter for each of the plurality of CMP modules 140/150/160. In other embodiments, at least one parameter may only be determined for a subset of the plurality of CMP modules. Embodiments are not limited to the type of determined parameter nor the number of modules for which at least one parameter is determined.

At act 206, the semiconductor wafer is processed by each of the CMP modules based on the respective determined parameter. By determining a recipe use by each of the CMP modules, the surface of the wafer may be made more uniform, both locally and globally. For example, if an incoming wafer has large variations across a wafer, the first polishing act of the first CMP module may not be sufficient to correct all of the variations. Accordingly, the subsequent polishing acts by the remaining CMP modules may be used to fine tune and further reduce the observed non-uniformities.

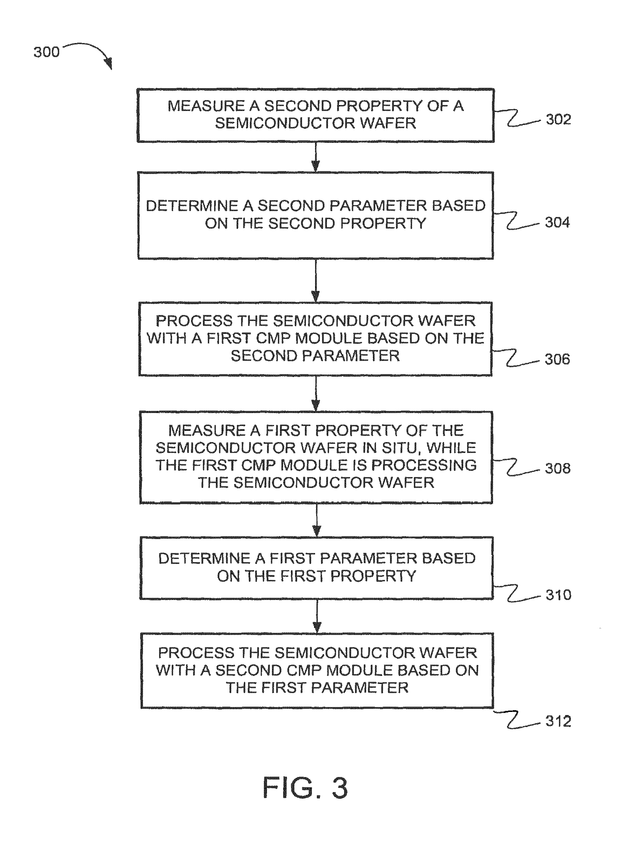

FIG. 3 is a flow chart of an exemplary method 300 for polishing a semiconductor wafer. The method 300 may be performed by components of the polishing tool and controlled by, for example, controller 170. At act 302, a second property of a semiconductor wafer is measured. As with act 202 of method 200, this measurement may be made in any suitable way. For example, the measurement 302 may be made by an inline metrology tool.

At act 304, a second parameter is determined based on the second property. This determination may be made, for example, by controller 170. The second parameter may be, for example, a portion of a recipe to be used by polishing tool 100. As with act 204 of method 200, the parameter may be any suitable parameter that determines the polishing action of one or more CMP modules. For example, the second parameter may be a parameter used by the first CMP module 140.

At act 306, the wafer being fabricated is processed with a first CMP module 140 based on the second parameter. As stated above, the second parameter may be any suitable parameter used to determine a property of a polishing act being performed by CMP module 140. For example, the second parameter may indicate a rotation speed of the platen 142, a rotation speed of the CMP head 141, a rotation speed of the conditioning arm 145, a pressure associated with the platen 142, a pressure associated with the CMP head 141, a slurry flow rate, a type of slurry or any other suitable parameter used to determine properties of a polishing act.

At act 308, a first property of the wafer is measured in situ while in a particular CMP module. The first property may be measured while the wafer is processed by first CMP module 140. In other embodiments, the first property may be measured after the CMP module 140 has completed the polishing act. As discussed above, any suitable type of in situ measurement known in the art may be used.

At act 310, a first parameter is determined based on the first property. As with above act 304, any suitable parameter of a polishing act may be used. At act 312, a second CMP module 150 processes the wafer based on the first parameter. For example, if the first parameter is a slurry flow rate, the second CMP module 150 may polish the wafer using the determined slurry flow rate.

Method 300 is an exemplary embodiment. Not every act is performed in all embodiments. For example, in some embodiments, acts 203, and 304 and 306 may not be performed. Moreover, embodiments may include additional acts not shown in method 300. For example, during act 312, an in situ measurement device may measure a third property of the wafer that may be used to determine parameters for subsequent polishing acts of the polishing process.

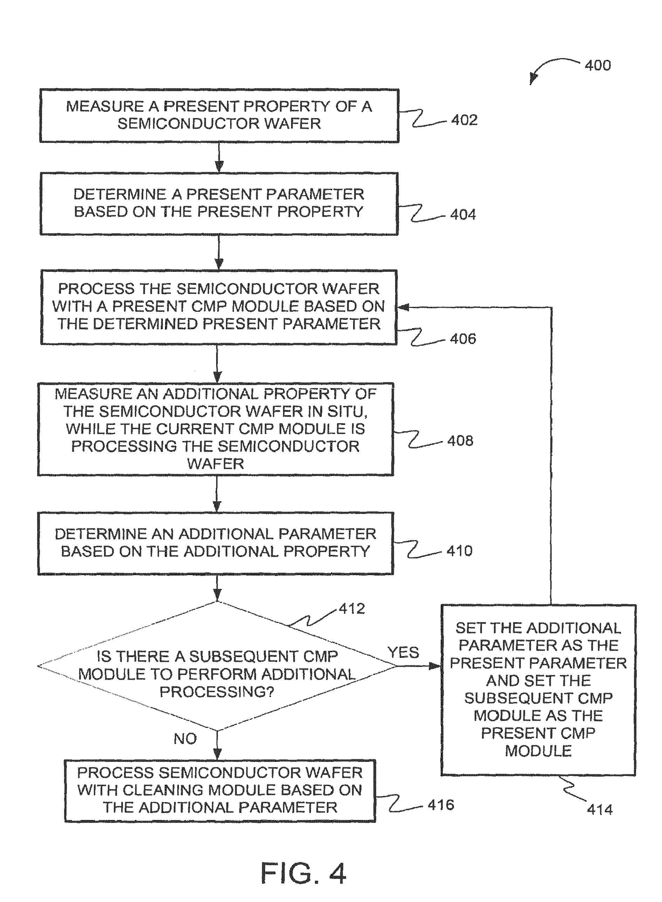

FIG. 4 is a flow chart of an exemplary method 400 for polishing a semiconductor wafer. The method 400 may be performed by components of the polishing tool and controlled by, for example, controller 170. At act 402, a present property of a semiconductor wafer is measured. As with act 202 of method 200, this may be done in any suitable way. For example, the measurement may be made by an inline metrology device 120. A present parameter is determined at act 404 based on the present measurement property. This may be done, for example, by controller 170.

At act 406, the semiconductor wafer is processed by a present CMP module based on the determined present parameter. For example, if the present parameter was a particular rotation speed of the platen, the platen of the CMP module is rotated at the determined speed. An additional property of the wafer is measured in situ at act 406. This measurement may be done in any suitable way. For example, various forms of optical, x-ray, acoustic, conductivity, and friction-based in situ measurement techniques are known in the art.

At act 408, an additional parameter is determined based on the additional property. For example, the additional parameter may be a parameter of a polishing act performed by a subsequent CMP module. The additional parameter may also be a parameter for use by a cleaning module 180 of CMP tool 100. For example, the parameter may indicate a type of chemistry to be used by the cleaning module 180.

At act 412, it is determined whether there are subsequent CMP modules to perform additional processing of the semiconductor wafer. If there are additional CMP modules, the determined additional parameter is set as the present parameter and the subsequent CMP module is set to the present CMP module at act 414. The method 400 then returns back to act 406 for additional processing. This loop continues until, at act 412, it is determined that there are no subsequent CMP modules for processing the wafer. When this determination is made, method 400 may continue to act 416, where the wafer is processed by cleaning module 180 based on the additional parameter determined in the final loop during act 410.

In some embodiments, not every act of method 400 is performed. For example, in some embodiments, when it is determined at act 412 that there are no subsequent CMP modules for processing the wafer, the wafer may be processed by the cleaning module without feedback from a previous measurement. In such an embodiment, a measurement may not be made at act 408 of the final loop through method 400. Additionally, in some embodiments, additional acts may be performed that are not shown in method 400. For example, more than one parameter may be determined during each loop through method 400. In such embodiments, the subsequent processing of the wafer may be performed based on the plurality of determined parameters.

In some embodiments, the methods of polishing a wafer may include at least one additional act of measurement performed by, for example, inline metrology device 120 after the polishing acts are complete. The measurement results may be used to determine if the wafer meets a specification and/or tolerances set by the user of the tool. If the specification is not met, the wafer may be returned to the polishing tool, or a different tool, for additional processing. In some embodiments, the controller 170 may determine, based on the measurement results, that the wafer is irreparable and should be deposed of.

In some embodiments, recipes for fabricating a wafer may comprise parameters detailing acts other than polishing. For example, measurements made by inline metrology tool 120 or in situ measurements may be used by controller 170 to determine parameters for use by a deposition tool or an etching tool. Embodiments are not limited to any particular number of parameters or types of parameters.

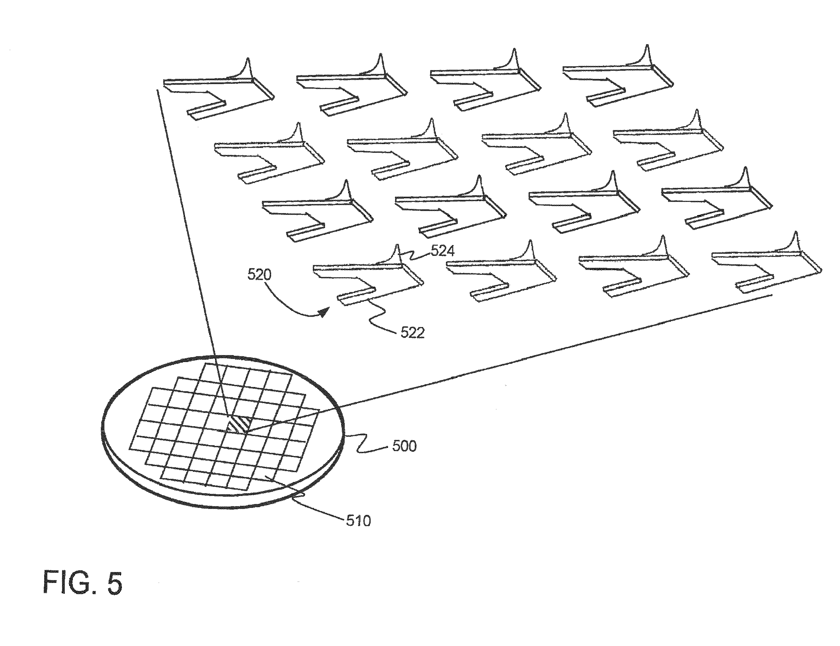

FIG. 5 illustrates a measurement probe that may be used to perform inline metrology of a wafer in some embodiments. Inline measurements are performed outside of any particular CMP module and may be performed at any time. For example, inline measurement may be performed before implementing a polishing process. The foregoing polishing apparatus and methods for manufacturing a semiconductor device are not limited to any particular inline metrology device 120. For example, an eddy current metrology device may be used in some embodiments to measure properties of a metal layer of the wafer. However, the inventor has recognized and appreciated that a faster, more precise measurement of wafer properties may be made using a measurement apparatus comprising a plurality of microprobes.

In some embodiments, a variant of atomic force microscopy, known as Kelvin probe force microscopy, may be used to measure properties of a wafer. It is known to use Kelvin probe force microscopy to obtain both height and surface charge information from a sample. However, by using a plurality of microprobes simultaneously, the height profile and surface charge profile of a wafer may be measured simultaneously at a plurality of points across a surface of the wafer.

FIG. 5 illustrates an exemplary measurement probe 500 that may be used to simultaneously measure height profiles and surface charge profiles at various positions on a surface of a wafer. The measurement probe 500 may comprise a plurality of microprobes 520. Each microprobe may comprise at least one cantilever 522 and a tip 524. In some embodiments, a tip 524 is integrated into the cantilever 522. In other embodiments, a dedicated tip 524 may not be used and the cantilever 522 itself acts as the tip. The microprobes 520 may be formed from any suitable material. For example, the microprobes 520 may be any conductive material such as a metal, a conductive polymer, or a carbon based material. In some embodiments, the microprobes 520 may be formed on a substrate. The substrate may be, for example, a semiconductor wafer.

The plurality of microprobes 520 may comprise a plurality of subsets 510. Each subset may comprise at least one microprobe 520. A subset may comprise a single microprobe or a plurality of microprobes. In some embodiments, the wafer being measured may include a plurality of devices. Each of the plurality of subsets may be associated with one of the devices of the wafer. In this way, the microprobes may be scanned over the surface of the wafer such that any particular subset of microprobes only scans the area of the wafer where the associated device is located. The more microprobes that are in each subset, the quicker the scan of the wafer may be. Any suitable number of microprobes 520 may be in a subset 510. FIG. 5 illustrates 52 subsets of microprobes, each subset 510 comprising sixteen microprobes 520. However, embodiments are not limited to any particular number of subsets or number of microprobes. For example, there may be only one microprobe per subset.

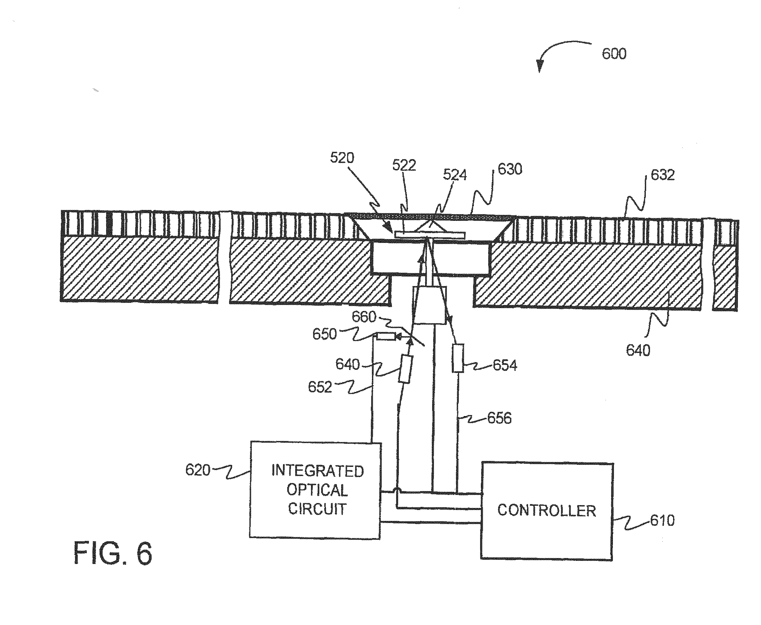

FIG. 6 illustrates a portion of one embodiment of a measurement probe 600 showing a single microprobe 520. The microprobe is a affixed to a substrate 640 in any suitable way. The substrate 640 is protected with a probe protection layer 632. Probe protection layer 632 may be formed from any suitable material. For example, an insulating material such as an oxide may be used to protect the substrate 640 using conventional wafer fabrication techniques. A microprobe protection membrane 630 may be used to protect the microprobe 520 from damage. For example, tip 524 may be susceptible to damage from contact with other objects. The microprobe protection membrane 620 may be formed from any suitable material. For example, a porous material may be used. In some embodiments, the porous material may be a microporous material with a pore size ranging from 20 nm to 200 nm. The porous material may be a material known in the art, such as a zeolite compound or a metal-organic framework.

A controller 610 may provide an electrical driving signal to the microprobe 520 as known in the art. The controller 610 may include a processor and/or circuitry for controlling the driving signal. For example, controller 610 may include a lock-in amplifier and/or a feedback controller such that the driving signal is determined based on a detected signal. The driving signal may be a sinusoidal signal at a frequency near the resonance frequency of the microprobe. In some embodiments, the frequency may be above the resonance frequency of the microprobe. In response to the driving signal, the microprobe is displaced relative to the wafer being measured due to a voltage difference between the microprobe and the wafer.

To measure the displacement of the microprobe 520, a light source 640 shines a light bean onto a surface of the microprobe 520. The light beam is reflected off the microprobe 520 and received by collection optics 654. Any suitable collection optics 654 may be used. For example, a lens, such as an objective lens or aspheric lens, may direct the reflected light beam into optical fiber. In some embodiments, the reflected light may be coupled directly into an integrated optical circuit. A portion of the light beam from light source 640 is reflected from a beam splitter 660 and coupled into a the integrated optical circuit 620 via an optical fiber using collection optics 650. Any suitable collection optics 650 may be used.

Integrated optical circuit 620 may comprise an interferometer for interfering the light reflected from beam splitter 660 with the light beam reflected from the microprobe 520. The interferometer may comprise at least one additional beam splitter for interfering the received light beams. A photodetector may also be included in the integrated optical circuit for detecting the optical interference signal. In other embodiments, a photodetector may be included in controller 610 and the optical interference signal may be directed to the controller 610 via optical fiber. Embodiments are not limited to any particular location of the photodetector.

In some embodiments, beam splitter 660 may be included in integrated optical circuit 620. In other embodiments, the beam splitter 660 may be implemented using optical fiber and optical fiber couplers, such as 2x2 couplers known in the art. In some embodiments, an integrated optical circuit is not used and the interferometer is implemented using optical fiber and optical fiber couplers.

In some embodiments light source 640 may be a laser that emits a light beam. The laser may be controlled by controller 610. However, embodiments are not so limited. For example, a single laser may be used to emit light for each of the plurality of light sources 640 associated with the measurement probe 500. For example, a single laser may be split into a plurality of light beams using beam splitters, such as optical fiber couplers. Each of the plurality of light beams may be transmitted to light source 640 via optical fiber. In such an embodiment, light source 640 may comprise collimation optics such that a collimated beam is emitted. Embodiments are not limited to any particular number of lasers. For example, one laser may be used for each subset of microprobe. The light beam emitted from a laser may be distributed to each of the plurality of microprobes in any suitable way. For example, a single laser may be time multiplexed and/or steered such that a light beam is directed to each of the plurality of microprobes sequentially.

The detection signals from the plurality of photodetectors may be used by the controller as feedback to the driving signal sent to each of the multiprobes. Any suitable lock-in and/or feedback technique may be used and are known in the art.

Using techniques known in the art, controller 610 may determine a height profile and surface charge profile of the measured wafer based on the detection signals generated by the plurality of photodetectors. Together, the plurality of microprobes 520 determine a local and global height profile and surface charge profile. Controller 610 may utilize these profiles to determine parameters to be used in the semiconductor manufacturing process, as described above.

Any number of controllers 610 may be used. FIG. 6 illustrates one controller per microprobe 520. However, embodiments are not so limited. A single controller may be used for all the microprobes, or a subset of the microprobes.

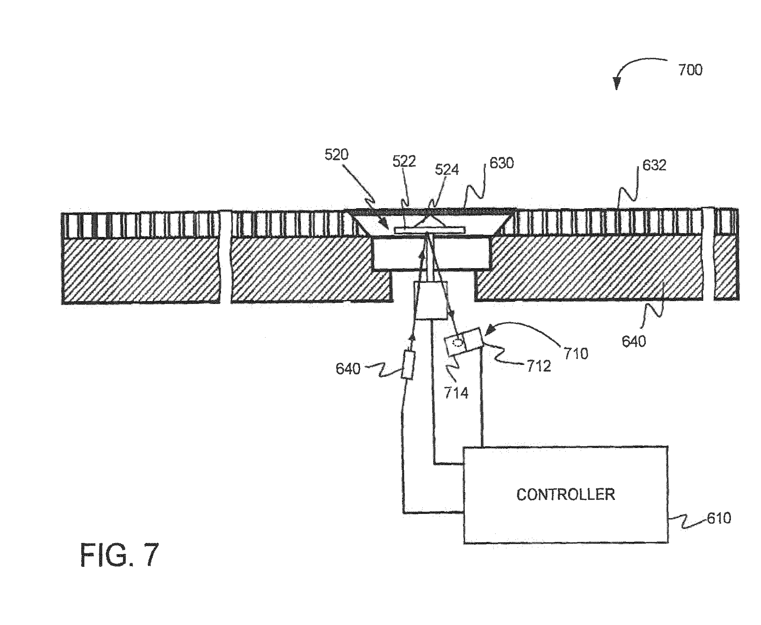

FIG. 7 illustrates a portion of another embodiment of a measurement probe 700 showing a single microprobe 520. Some of the components shown in FIG. 7 are the same or similar to the component described in FIG. 6 and are labeled with the same identification number.

In this embodiment, probe 700 does not use an interferometer to measure the displacement of the microprobe 520. Instead, a photodetector 710 comprising a plurality of segments is used to detect the light beam reflected from the microprobe 520. For example, FIG. 7 illustrates a photodetector 710 with two segments 712 and 714. Embodiments are not so limited, as any suitable number of segments may be used. The reflected light beam has a spot size, and the position of the light beam spot on the photodetector 710 is based on the displacement of microprobe 520. Each segment of the photodetector may output its own associated detection signal. Controller 610 may use, for example, the difference between the two signals to determine the displacement of the microprobe 520.

Though the embodiments discussed above describe the use of an interferometer and multi-segment photodetectors to measure the displacement of each of the microprobes 520, any suitable technique may be used. Embodiments are not limited to any particular measurement technique.

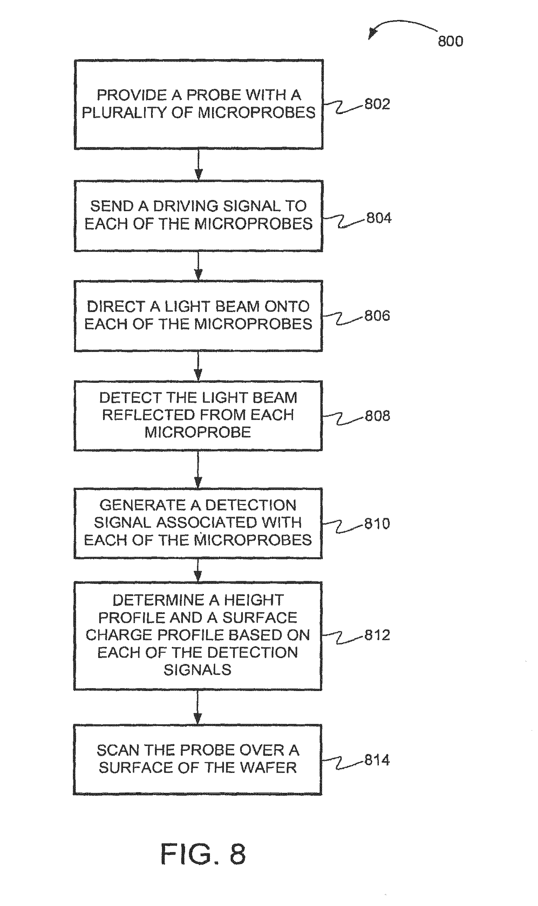

FIG. 8 is a flow chart illustrating an exemplary method 800 for producing a semiconductor device. At act 802, a probe with a plurality of microprobes is provided. As described above, the microprobes may comprise a cantilever and a tip and may be segregated into subsets associated with semiconductor devices on a wafer.

At act 804, a driving signal is sent to each of the microprobes. This may be done, for example, using a controller. The driving signal may be a sinusoidal signal and based, in part, on a detection signal received from at least one photodetector used to measure the displacement of each respective microprobe.

At act 806, a light beam from a light source is directed onto each of the microprobes. The light beam may originate from any suitable light source. For example, the light source could be a laser. In some embodiments, a single laser may be split into a plurality of light beams using beam splitters, such as optical fiber couplers. Each of the plurality of light beams may be transmitted to light source 640 via optical fiber. In such an embodiment, light source 640 may include collimation optics such that a collimated beam is emitted. Embodiments are not limited to any particular type of light source.

At act 808, the light beam reflected from each of the microprobes is detected by at least one photodetector. This may be done in any suitable way. For example, the reflected light beam may be interfered with a reference light beam resulting in an optical interference signal. The optical interference signal may be detected by a photodetector. Alternatively, a photodetector comprising a plurality of segments may detect the light reflected from the microprobe. In other embodiments, a single laser may be time multiplexed and/or steered such that a light beam is directed to each of the plurality of microprobes sequentially. Embodiments are not limited to any particular technique for detecting the reflected light beam.

At act 810, a detection signal associated with each of the microprobes is generated. In some embodiments, the detection signal may comprise a plurality of signals. For example, if a segmented photodetector is used in act 808, then the detection signal may comprise a segment signal associated with each of the plurality of segments.

At act 812, a height profile and/or a surface charge profile may be determined based on each of the detection signals. For example, Kelvin probe force microscope techniques are known in the art for determining the height and surface charge profiles based on detections signals. Embodiments are not limited to any particular technique for determining the profiles from the detection signals.

At act 814, the measurement probe is scanned over the surface of a wafer. As described above, the more microprobes on the measurement probe, the less scanning time is required and the quicker the measurement of local and global uniformity is. The measurement probe may be scanned in any suitable way. For example, in some embodiments, the wafer may be moved while the measurement probe is kept stationary. In other embodiments, both the measurement probe and the wafer may be scanned relative to one another.

The acts of method 800 are not required in every embodiment, nor are embodiments limited to just the acts illustrated in method 800. For example, additional acts may include determining one or more fabrication parameters to be used by one or more fabrication tool, such as a CMP tool or a cleaning module. The parameters may be sent to the tools for use in manufacturing one or more semiconductor devices.

The above-described embodiments can be implemented in any of numerous ways. For example, some embodiments may be implemented using hardware, software or a combination thereof. When implemented in software, the software code can be executed on any suitable processor or collection of processors, whether provided in a single computer or distributed among multiple computers. Such processors may be implemented as integrated circuits, with one or more processors in an integrated circuit component. Though, a processor may be implemented using circuitry in any suitable format.

Further, it should be appreciated that a computer may be embodied in any of a number of forms, such as a rack-mounted computer, a desktop computer, a laptop computer, or a tablet computer.

Such computers may be interconnected by one or more networks in any suitable form, including as a local area network or a wide area network, such as an enterprise network or the Internet. Such networks may be based on any suitable technology and may operate according to any suitable protocol and may include wireless networks, wired networks or fiber optic networks.

Also, the various methods or processes outlined herein may be coded as software that is executable on one or more processors that employ any one of a variety of operating systems or platforms. Additionally, such software may be written using any of a number of suitable programming languages and/or programming or scripting tools, and also may be compiled as executable machine language code or intermediate code that is executed on a framework or virtual machine.

In this respect, embodiments may comprise a computer readable storage medium (or multiple computer readable media) (e.g., a computer memory, one or more floppy discs, compact discs (CD), optical discs, digital video disks (DVD), magnetic tapes, flash memories, circuit configurations in Field Programmable Gate Arrays or other semiconductor devices, or other tangible computer storage medium) encoded with one or more programs that, when executed on one or more computers or other processors, perform methods that implement the various embodiments discussed above. As is apparent from the foregoing examples, a computer readable storage medium may retain information for a sufficient time to provide computer-executable instructions in a non-transitory form. Such a computer readable storage medium or media can be transportable, such that the program or programs stored thereon can be loaded onto one or more different computers or other processors to implement various aspects embodiments as discussed above. As used herein, the term "computer-readable storage medium" encompasses only a computer-readable medium that can be considered to be a manufacture (i.e., article of manufacture) or a machine. Alternatively or additionally, embodiments may comprise a computer readable medium other than a computer-readable storage medium, such as a propagating signal.

The terms "program" or "software" are used herein in a generic sense to refer to any type of computer code or set of computer-executable instructions that can be employed to program a computer or other processor to implement various aspects of the embodiments as discussed above. Additionally, it should be appreciated that according to one aspect of this embodiment, one or more computer programs that when executed perform methods of the embodiments need not reside on a single computer or processor, but may be distributed in a modular fashion amongst a number of different computers or processors to implement various aspects of the embodiments.

Computer-executable instructions may be in many forms, such as program modules, executed by one or more computers or other devices. Generally, program modules include routines, programs, objects, components, data structures, etc. that perform particular tasks or implement particular abstract data types. Typically the functionality of the program modules may be combined or distributed as desired in various embodiments.

Also, data structures may be stored in computer-readable media in any suitable form. For simplicity of illustration, data structures may be shown to have fields that are related through location in the data structure. Such relationships may likewise be achieved by assigning storage for the fields with locations in a computer-readable medium that conveys relationship between the fields. However, any suitable mechanism may be used to establish a relationship between information in fields of a data structure, including through the use of pointers, tags or other mechanisms that establish relationship between data elements.

Various aspects of the embodiments may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

Also, embodiments may be a method, of which an example has been provided. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including," "comprising," or "having," "containing," "involving," and variations thereof herein, is meant to encompass the items listed thereafter and equivalents thereof as well as additional items.

Having thus described several aspects of at least one embodiment of this invention, it is to be appreciated that various alterations, modifications, and improvements will readily occur to those skilled in the art. Such alterations, modifications, and improvements are intended to be part of this disclosure, and are intended to be within the spirit and scope of the invention. Further, though advantages of the present invention are indicated, it should be appreciated that not every embodiment of the invention will include every described advantage. Some embodiments may not implement any features described as advantageous herein and in some instances. Accordingly, the foregoing description and drawings are by way of example only.

## Claims

1. An apparatus for performing metrology of a wafer, the apparatus comprising:
a substrate;
a plurality of microprobes on the substrate;
at least one light source, wherein the at least one light source directs light onto one of the plurality of microprobes;
a plurality of photodetectors for detecting the light reflected from each of the plurality of microprobes, wherein detecting the light comprises generating a detection signal associated with each of the microprobes; and
at least one controller for:
sending a driving signal to each of the plurality of microprobes; and
determining a height profile and a surface charge profile of the wafer based on each of the detection signals.

2. The apparatus of claim 1, wherein:
the wafer comprises a plurality of devices; and
the plurality of microprobes comprises a plurality of subsets, each of the plurality of subsets comprising one or more of the plurality of microprobes, wherein each of the plurality of subsets is associated with one of the plurality of devices of the wafer.

3. The apparatus of claim 2, wherein:
each of the plurality of subsets comprises more than one of the plurality of microprobes.

4. The apparatus of any preceding claim, wherein:
in response to the determined height profile and the determined surface profile, the at least one controller transmits at least one fabrication parameter to a fabrication tool for processing the wafer.

5. The apparatus of any preceding claim, further comprising:
a plurality of protective membranes for protecting the plurality of microprobes.

6. The apparatus of claim 5, wherein:
the plurality of protective membranes are formed from a porous material.

7. The apparatus of claim 6, wherein:
the porous material has a pore size between 20 nm and 200 nm and/or the porous material is a zeolite compound or a metal-organic framework.

8. The apparatus of any preceding claim, wherein:
each of the plurality of photodetectors is a segmented photodiode comprising a plurality of segments;
the detection signal comprises a plurality of segment signals, each of the plurality of segment signals being from a respective segment of the photodiode; and
the height profile and surface charge profile is determined from the plurality of segment signals.

9. The apparatus of any preceding claim, wherein:
before being detected by the plurality of photodetectors, the light reflected from each of the plurality of microprobes is input into a respective interferometer.

10. A method of manufacturing a semiconductor device on a wafer, the method comprising:
providing a measurement probe comprising a plurality of microprobes;
sending a driving signal to each of the plurality of microprobes;
directing light onto each of the plurality of microprobes;
detecting the light reflected from each of the plurality of microprobes;
generating a detection signal associated with each of the microprobes; and
determining a height profile and a surface charge profile of the wafer based on each of the detection signals.

11. The method of claim 10, further comprising:
scanning the measurement probe over a surface of the wafer.

12. The method of claim 11, wherein:
the wafer comprises a plurality of semiconductor devices; and
the plurality of microprobes comprises a plurality of subsets, each of the plurality of subsets comprising one or more of the plurality of microprobes, wherein each of the plurality of subsets is scanned over only one of the plurality of devices of the wafer.

13. The method of any of claims 10 to 12, wherein:
each of the driving signals is generated based in part on a respective detection signal.

14. The method of any of claims 10 to 13, wherein:
detecting the light reflected from each of the plurality of microprobes comprises detecting the reflected light at a respective segmented photodiode comprising a plurality of segments;
each of the detection signals comprises a plurality of segment signals, each of the plurality of segment signals being from a respective segment of the respective segmented photodiode; and
the height profile and surface charge profile is determined from the plurality of segment signals.

15. The method of any of claims 10 to 14, further comprising:
directing the light reflected from each of the plurality of microprobes through an interferometer.

16. The method of any of claims 10 to 15, further comprising:
transmitting at least one fabrication parameter to a fabrication tool for processing the wafer, wherein the at least one fabrication parameter is based on the height profile and/or the surface charge profile.

17. The method of any of claims 10 to 16, wherein:
directing the light onto each of the plurality of microprobes comprises emitting the light from a laser and directing a portion of light onto each of the plurality of microprobes.
